**Europäisches Patentamt**

**European Patent Office**

**Office européen des brevets**

(11) Veröffentlichungsnummer: **0 256 164 B1**

(12) **EUROPÄISCHE PATENTSCHRIFT**

(45) Veröffentlichungstag der Patentschrift: **15.01.92**

(51) Int. Cl.⁵: **H05K 13/00**

(21) Anmeldenummer: **86113951.7**

(22) Anmeldetag: **08.10.86**

(30) Priorität: **18.07.86 DE 3624333**
**10.09.86 EP 86112495**

(43) Veröffentlichungstag der Anmeldung:
**24.02.88 Patentblatt 88/08**

(45) Bekanntmachung des Hinweises auf die
Patenterteilung:
**15.01.92 Patentblatt 92/03**

(84) Benannte Vertragsstaaten:
**AT BE CH DE FR GB IT LI LU NL SE**

(56) Entgegenhaltungen:
**DE-A- 3 437 820**

(73) Patentinhaber: **Stucki Kunststoffwerk und**
**Werkzeugbau GmbH.**
**Schötmarsche Strasse**
**W-4902 Bad Salzuflen 1(DE)**

(72) Erfinder: **Korte, Klaus, Techn.**
**Falkenweg 7**
**W-4902 Bad Salzuflen 1(DE)**

(74) Vertreter: **Junius, Walther, Dr.**
**Wolfstrasse 24**
**W-3000 Hannover 81(DE)**

(54) **Vorrichtung für den Transport von Leiterplatten.**

## Beschreibung

Die Erfindung betrifft eine Vorrichtung für den Transport von Leiterplatten, bestehend aus einem Kasten und hohlen, innen mit Aussteifungsrippen versehenen Halteplatten, die an ihren Außenseitenflächen eine Vielzahl paralleler Rippen tragen und die mittels sie durchsetzender von einer Kastenwand zur gegenüberliegenden Kastenwand sich erstreckenden Stangen zu einer Einheit zusammengehalten sind, wobei die Stangen durch geschlitzte, mit Gewinde versehene rohrförmige Ansätze an den Halteplatten gesteckt sind und durch auf die Gewinde aufgeschraubte Muttern geklemmt sind.

Diese Vorrichtung kann in einen Transportkasten aus Kunststoff hineingesetzt werden, sie kann aber z.B. im innerbetrieblichen Transport auch selbständig eingesetzt werden. Sie kann auch zur Lagerung von Leiterplatten dienen.

Eine derartige Vorrichtung ist aus dem DE-U 83 32 295 bekannt geworden. Sie dient für den Transport von Leiterplatten (gedruckte Schaltungen), die mit elektronischen Bauteilen bestückt sind, von dem Herstellungsbetrieb dieser Schaltungsplatten zu dem Verwender, der diese Schaltungsplatten in elektronische oder elektronisch gesteuerte Geräte einbaut. Die Halteplatten sind mittels sie durchsetzender Rohre auf einem bestimmten, den Leiterplattendimensionen entsprechenden Abstand voneinander angeordnet, die Rohrlänge entspricht der Innenraumlänge des Transportkastens. So lassen sich Formen für die Herstellung herkömmlicher Transportkästen, die wegen ihrer weiten Verwendung in der Lebensmittel- und in anderen Industrien in großer Stückzahl und dadurch billig aus Kunststoff hergestellt werden können, auch für die Herstellung von Kästen für den Transport von Leiterplatten verwenden, insbesondere dann, wenn die Kästen aus speziell für diesen Zweck geeigneten Kunststoffen hergestellt werden.

Diese Transportmittel lassen sich auch weitgehend der einen Leiterplattendimension durch Verstellen der Halteplattenabstände auf den Rohren anpassen. In der anderen Dimension bereitet jedoch eine Anpassung sehr große Schwierigkeiten und daher müssen verschiedene Halteplatten unterschiedlicher Höhe auf Lager gehalten werden, wenn der Raum im Inneren der Transportkästen möglichst weitgehend ausgenutzt werden soll. Für schmale Leiterplatten sind niedrige Halteplatten vorzusehen, die dann im Kasten als Ensemble mit den Rohren und bestückt mit Leiterplatten übereinandergestellt werden können, was jedoch die Gefahr in sich birgt, daß diese übereinandergestapelten Ensembles im Transport ineinanderrutschen, wodurch die Leiterplatten oder deren Bauteilbestückung beschädigt werden können, was auf jeden Fall zu vermeiden ist. Daher werden, von Ausnahmen vielleicht abgesehen, in einem Transportkasten immer nur ein Ensemble transportiert, auch wenn zwei Drittel oder mehr des Transportkasteninnenraumes ungenutzt bleiben.

Wichtig bei dieser Vorrichtung ist es, daß die Leiterplatten problemlos in die Vorrichtung eingesetzt werden können, ohne daß sie beschädigt werden, was nicht nur für die Beladung von Hand, sondern auch für die Be- und Entladung der Vorrichtung mit Leiterplatten durch Roboter bedeutsam ist.

Die Erfindung vermeidet die Nachteile des Standes der Technik. Es ist die Aufgabe der Erfindung, eine einfache Möglichkeit zu schaffen, um mit möglichst wenig Bauteilen von möglichst gleicher Form Transportkästen problemlos insbesondere mit Robotern be- und entladen zu können.

Die Erfindung besteht darin, daß die Rippen an der Außenseite der Halteplatten sich an ihrem oberen Ende in ihrer Breite unter Bildung von Einführungsschrägen verjüngen und daß der Plattenquerschnitt sich am oberen Ende unter Bildung mindestens einer weiteren Einführungsschräge verjüngt.

Eine Vorrichtung mit derartigen Halteplatten kann leicht von Hand, aber auch problemlos von Robotern be- und entladen werden. Die Einführungsschrägen gewährleisten, daß die Leiterplatten beschädigungslos in die Schlitze zwischen den Rippen eingeführt werden, wo sie für den Transport den geeigneten Halt finden.

Von Vorteil ist es, wenn zwischen den sich verjüngenden Teilen der Rippen oder über den Zwischenräumen zwischen den Rippen Löcher für die Aufnahme von Sperrstiften angeordnet sind. Mit elektronischen Bauteilen bestückte Leiterplatten benötigen eine bestimmte Breite bei der Stapelung in der Vorrichtung des Transportkastens. Die in die genannten Löcher eingesetzten Sperrstifte verhindern, daß Leiterplatten in Schlitze zwischen Rippen eingeführt werden können, die zur Aufrechterhaltung der notwendigen Breite nicht mit Leiterplatten bestückt werden dürfen. Die Sperrstifte können gleichzeitig einem Fühlorgan des Roboters als Hilfsmittel dienen, um diejenigen Schlitze aufzufinden, die für das Einschieben von Leiterplatten bestimmt sind.

Die Erfindung schafft auch die Möglichkeit, Leiterplatten in mehreren Etagen übereinander in ein und demselben Transportkasten zu transportieren, aber auch Leiterplatten zu transportieren, deren Breitendimension größer als die Halteplattenbreite ist, sogar ein Mehrfaches der Halteplattenbreite beträgt. Dies wird dadurch erreicht, daß mindestens zwei Halteplatten mit gleicher Rippenanordnung übereinander angeordnet sind und durch Klammern miteinander verbunden sind. Damit diese übereinander angeordneten Halteplatten auch gut zentriert sind, so daß die Schlitze zwischen den Rippen exakt in jeweils einer Flucht liegen, so daß ein Leiterplattenrand in zwei übereinander angeordneten Schlitzen von zwei übereinander angeordneten Halteplatten liegen, ist vorzugsweise die obere Stirnseite mindestens einer Halteplatte mit mindestens einem Vorsprung versehen, der in die hohle untere Stirnseite der darüber angeordneten Platte hineinreicht. Damit die Leiterplattenkante nicht unten auf dem Transportkastenboden aufsteht, insbesondere dann nicht, wenn Kontakte über den unteren Rand der Leiterplatte hinausreichen, ist vorzugsweise an der unteren Platte mit Abstand vom unteren Ende und unter der Unterkante der Rippen eine bodenparallele Leiste angeordnet. Diese Leiste fehlt an der darüber angeordneten und mit einer Klammer befestigten Platte. Halteplatten mit oder ohne Leiste lassen sich in der gleichen Herstellungsform herstellen, wenn diese Form einen Einsatz besitzt, mit dem die Vertiefung für die Formung der Leiste ausgefüllt wird, wenn die Leiste an der Halteplatte nicht gewünscht wird.

Eine andere Möglichkeit besteht darin, daß lediglich gleichgeformte Halteplatten hergestellt werden, bei denen im unteren Bereich jeder Seitenwand mit Abstand von der Unterkante der Halteplatte Löcher für die Aufnahme von Stiften in einer bodenparallelen Reihe zwischen je zwei Rippen oder in der Flucht der Rippenzwischenräume unter diesen angeordnet sind. Während des Transportes stehen die Leiterplatten mit ihrer unteren Ecke auf diesen Stiften auf, die in die Löcher eingesetzt sind.

Bei dieser Ausführungsform kann es zweckmäßig sein, wenn in die hohle, von unten her offene Halteplatte ein aus zwei federnd miteinander verbundenen Wandungen bestehendes Bauteil einsetzbar ist, welches im Abstand der Löcher an seinen Außenseitenflächen angeordnete Stifte trägt, die einen geringeren Durchmesser als den Lochdurchmesser aufweisen. Diese Stifte sind länger als es die Wandstärke der Halteplatte ist. Auf diese Weise läßt sich eine Vielzahl von Stiften in einer einzigen Arbeitsoperation einsetzen. - Hierbei ist es vorteilhaft, wenn die beiden mit Stiften besetzten Wänden an den Schmalseiten durch ein zusammendrückbares Materialteil, vorzugsweise in U-, V- oder gerundeter Form, einstückig miteinander verbunden sind. Bei diesen Ausführungsformen können Stifte nicht verlorengehen, das Einsatzteil ist leicht montierbar und auch demontierbar.

Vorteilhaft ist es, wenn die Klammern U-Form im Querschnitt aufweisen und an den Innenseiten eines jeden Schenkels mindestens ein Paar von Vorsprüngen aufweisen, welche in Löcher in den Außenseitenflächen der Halteplatten eingreifen. Diese Klammern lassen sich leicht herstellen und geben einen sicheren Halt zwischen zwei miteinander zu verbindenden Halteplatten. Hierbei ist es zweckmäßig, wenn die Innenseite der Klammern formschlüssig an der Außenseite der Halteplatte anliegt. Dann ergibt sich eine feste Verbindung zwischen den beiden übereinander angeordneten Halteplatten.

Derartige Klammern lassen sich mit Vorteil aus Blech herstellen, wobei es zweckmäßig ist, daß die Vorsprünge an der Klammer durch winkelförmige Einschnitte in die Außenkanten einer aus Blech hergestellten Klammer und Abbiegen des im Einschnitt liegenden Materials nach innen hergestellt sind. Das ist eine einfache Herstellungsmöglichkeit, die zu einer festen Verklammerung führt.

Das Aufschieben von Klammern auf die Halteplatten wird dann besonders einfach, wenn zwischen jedem Loch in der Halteplatte für die Aufnahme eines Vorsprunges an der Klammer und der Außenkante der Halteplatte eine keilförmige, senkrecht zur Außenkante verlaufende Vertiefung angeordnet ist, welche ihre größte Tiefe an der Außenkante und ihre geringste Tiefe an der Ausnehmung aufweist.

Die durch die Einführungsschrägen erleichterte Einführung der Halteplatten in die Vorrichtung kann noch dadurch insbesondere für die Beschickung mit Robotern und die Entladung durch Roboter erleichtert werden, daß die obere Stirnfläche der Halteplatte mindestens ein der Zentrierung dienendes Loch aufweist.

Damit die Montage der Vorrichtung aus Halteplatten und Stangen besonders einfach und hochgenau wird, ist es zweckmäßig, wenn die Stange Mittel für die Arretierung, vorzugsweise in Form von Löchern, Kerben, Zähnen oder dergleichen aufweist und wenn an der Platte, insbesondere am oder neben dem rohrförmigen Ansatz mit diesen Mitteln zusammenarbeitende Mittel, vorzugsweise in Form von Splinten, Löchern, Bolzen, Federn, Zähnen, Haken angeordnet sind. Dieses wird noch dadurch erleichtert, wenn die Stäbe rechteckförmigen Querschnitt aufweisen.

Das Wesen der Erfindung ist nachstehend anhand von in der Zeichnung schematisch dargestellten Ausführungsbeispielen näher erläutert. Es zeigen:

| Fig. 1 | eine Ansicht von oben in einen mit Halteplatten, Rohren und Leiterplatten bestückten Transportkasten, |
| Fig. 2 | eine Ansicht einer Halteplatte von der Seite, |
| Fig. 3 | eine Ansicht der Halteplatte von oben, |
| Fig. 4 | eine Ansicht der Halteplatte von unten, |
| Fig. 5 | eine Ansicht der Halteplatte von unten mit eingesetzter Stiftleiste, |
| Fig. 6 | einen Querschnitt durch die Halteplatte, |

| Fig. 7 | eine Ansicht der Stiftleiste von oben, |
| Fig. 8 | eine Ansicht der Klammer von der Seite, |
| Fig. 9 | eine Ansicht der Klammer auf deren Innenseite, |
| Fig. 10 | eine Ansicht der Klammer von oben, |
| Fig. 11 | eine Ansicht zweier zusammengeklammerter Halteplatten, von denen die untere eine bodenparallele Leiste aufweist, |
| Fig. 12 | die beiden Halteplatten in Seitenansicht ohne Klammern. |

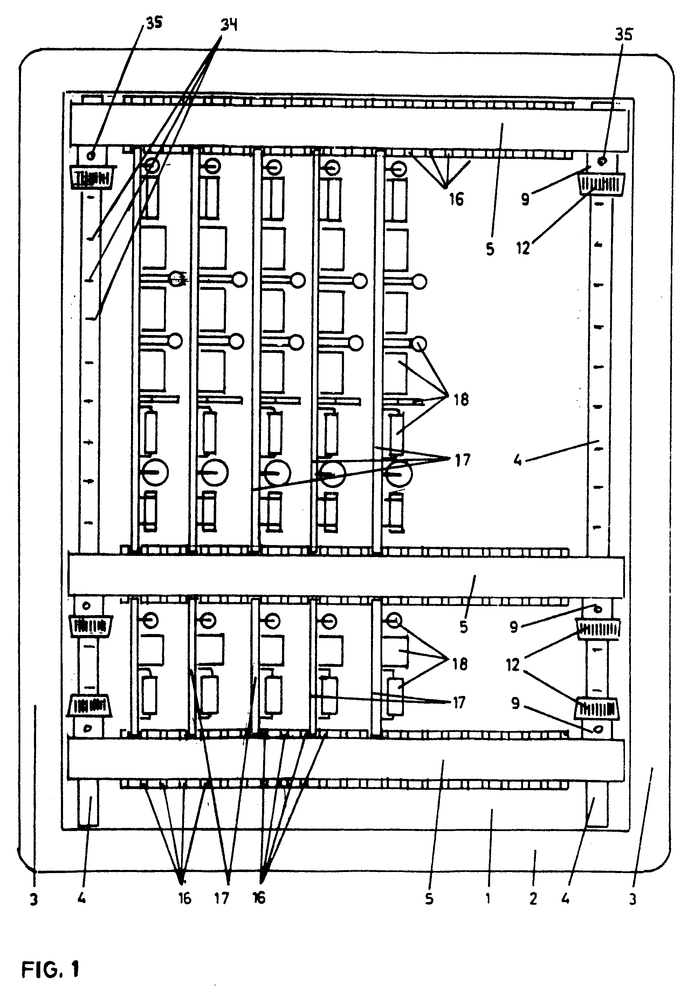

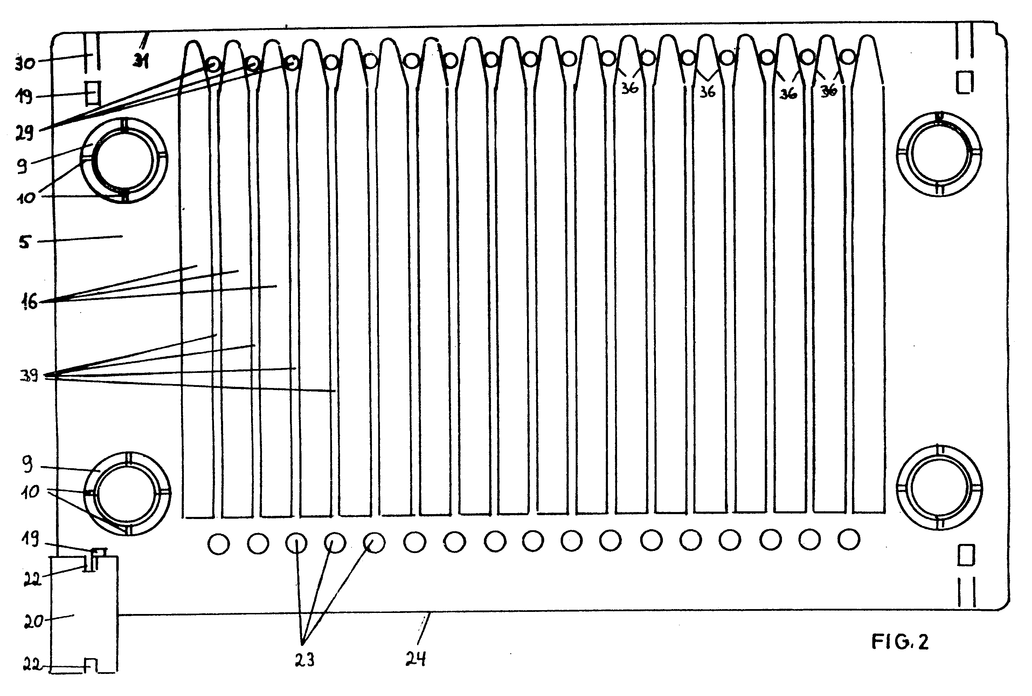

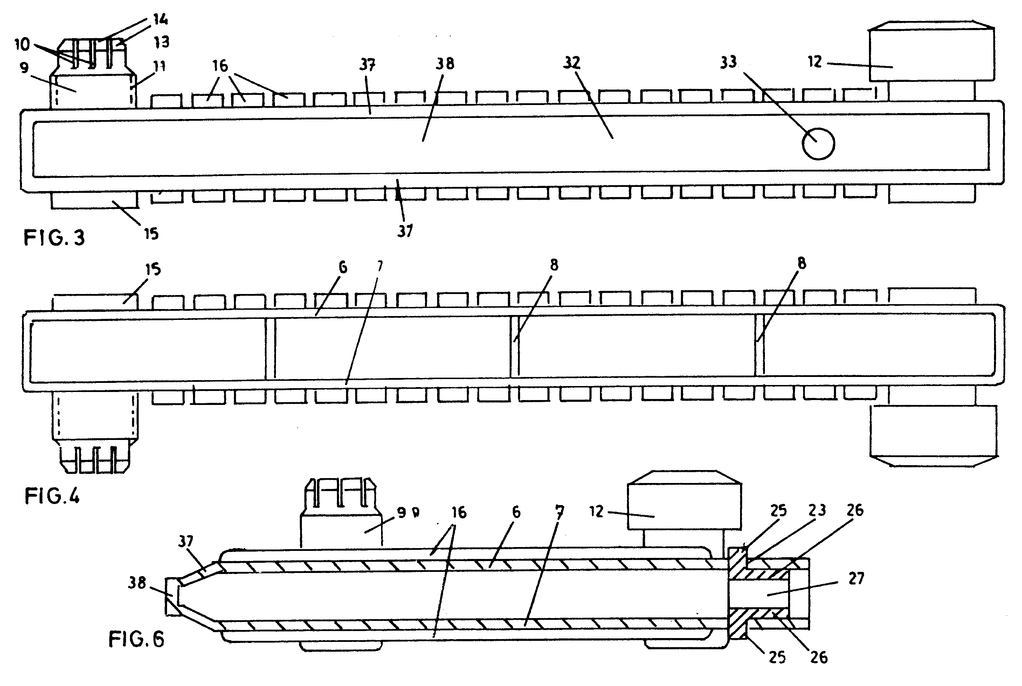

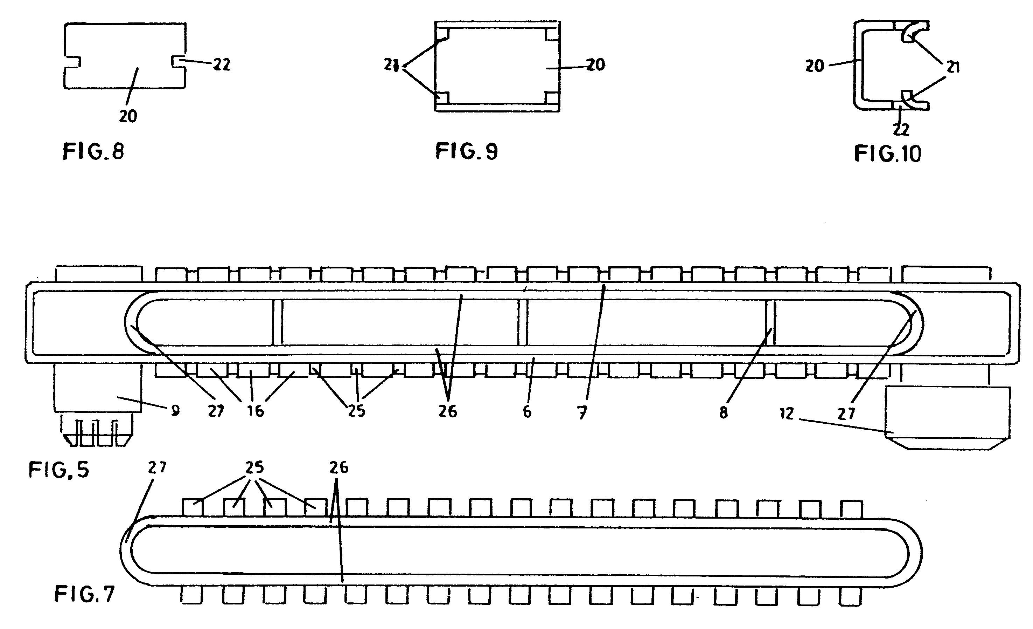

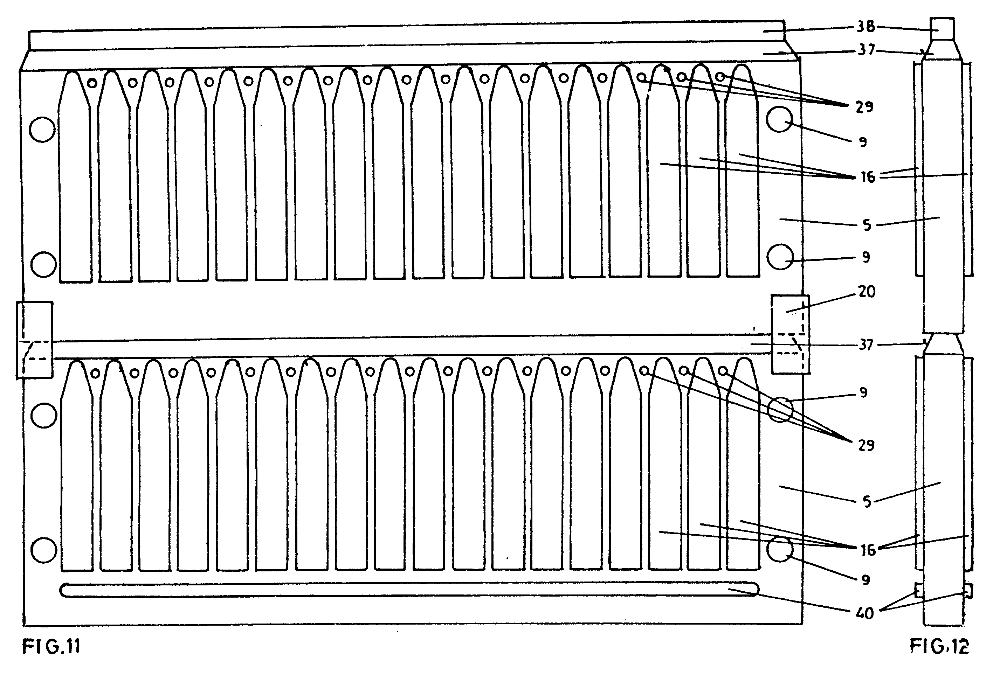

Fig. 1 zeigt einen Kasten aus Kunststoff, der einen Boden 1 mit je zwei gegenüberliegenden Seitenwänden 2, 3 aufweist. In den Kasten eingesetzt sind Stangen 4 mit drei Halteplatten 5. Diese Halteplatten 5 sind verschiebbar und feststellbar auf den Stangen 4 angeordnet. Die Stangen 4 durchsetzen Löcher in diesen Halteplatten 5.

Jede Halteplatte 5 ist ein einstückiges Formteil aus Kunststoff, welches aus zwei Wänden 6, 7 besteht, die durch Rippen 8 miteinander verbunden sind. Jede dieser doppelwandigen Halteplatten 5 weist auf ihrer einen Seitenwandfläche mindestens zwei Rohransätze 9 auf, durch deren Hohlen Innenraum, also durch deren Loch, sich jeweils eine Stange 4 erstreckt. Jeder Rohransatz 9 ist endseitig mit Schlitzen 10 versehen und trägt ein Gewinde 11, auf welches eine Mutter 12 aufgeschraubt ist, die in ihrem Inneren leicht konisch ausgebildet ist und sich mit dem hier ausgebildeten Konus gegen den Konus 13 am Ende des Rohransatzes 9 anlegt und beim Festschrauben die einzelnen, zwischen den Schlitzen 10 gebildeten Laschen 14 fest gegen die Stange 4 preßt.

Die Stangen 4 sind mit Einkerbungen 34 versehen, die Ansätze 9 sind mit Löchern 35 versehen, in die federnde Rasten 35 eingesetzt sind, die in die Kerben einfallen und die Halteplatten auf den Stangen vor dem Festziehen der Muttern zentrieren. Solche Zentrierungen können auch mit anderen Mitteln, wie Löchern in Stange 4 und Ansatz 9 und durchgesteckte Stifte, Bolzen, Splinte u. dgl., erreicht werden.

Auch auf der den Rohransätzen 9 gegenüberliegenden Seitenfläche der Halteplatte 5 können Rohransätze 15 ausgebildet sein, welche als Führungs- bzw. Lageröse dienen. Hierdurch wird erreicht, daß die Halteplatten 5 sehr exakt senkrecht auf den Rohren 4 sitzen und dadurch sehr exakt parallel zu einer oder mehreren weiteren Halteplatten 5 angeordnet sind.

Die Halteplatten 5 weisen auf beiden Seiten Rippen 16 auf. In die Zwischenräume zwischen die Rippen 16 werden die Leiterplatten 17 mit ihren Kanten eingesteckt. Die Rippen 16 verjüngen sich an ihrem oberen Ende unter Bildung von Einführungsschrägen 36, die das Einstecken von Leiterplatten 17 erleichtern.

Da durch Lösen der Muttern 12 die Halteplatten 5 verschiebbar und durch Festschrauben der Muttern 12 feststellbar sind, lassen sich die Halteplatten 5 auf beliebige Abstände voneinander einstellen. Dabei ist es nicht notwendig, daß die Halteplatten 5 an den Seitenwänden des Kunststoffkastens anliegen, ihre unverrückbare Stellung im Kunststoffkasten läßt sich dadurch erzielen, daß die Enden der Rohre 4 an der Seitenwand des Kunststoffkastens anliegen.

Am oberen Ende der mit Rippen 16 besetzten Seitenflächen verjüngt sich die Halteplatte 5 in ihrem Querschnitt unter Bildung von weiteren Einführungsschrägen 37 und läuft in mindestens einen Vorsprung 38 aus, der in seinen Abmessungen so gestaltet ist, daß er in eine unten offene Halteplatte 5 zentrierend oder klemmend einfaßt.

Auf jeder Leiterplatte können eine Vielzahl von elektronischen Bauelementen 18, wie Kondensatoren, Widerständen, Transistoren, Dioden usw. angeordnet sein. Diese sind sicher vor Beschädigung dadurch geschützt, daß der Abstand zwischen den einzelnen Leiterplatten 17 durch die exakte Einstellmöglichkeit der Halteplatten 5 gegeben ist. Da die Stangen 4 nicht im Kasten befestigt zu sein brauchen, kann das aus den Stangen 4 und den plattenförmigen Halteplatten 5 bestehende Ensemble für sich aus dem Transportkasten herausgenommen werden und für sich vor der die einzelnen Leiterplatten weiterverarbeitenden Person oder Maschine aufgestellt werden. Die einzelnen bestückten oder unbestückten Leiterplatten sind dann besonders gut zugänglich.

Die Halteplatten 5 weisen im Bereich ihrer Ecken je ein Loch 19 auf, welches zum Befestigen je einer Klammer 20 dient, um mehrere Halteplatten 5 miteinander zu verbinden.

Die Klammern 20 sind als im Querschnitt U-förmige Bauteile aus Blech gebogen und weisen Vorsprünge 21 auf, die nach innen gerichtet sind. Diese Vorsprünge sind dadurch hergestellt, daß winkelförmige Einschnitte 22 in das Blech eingestanzt sind und das zwischen Außenkante und winkelförmigem Einschnitt 22 befindliche Material nach innen abgebogen ist.

In Fig. 2 ist am rechten unteren Ende der Halteplatte 5 eine Klammer 20 angesetzt. In diese ist nach unten hin in ihren freien Teil eine weitere Halteplatte 5 einzusetzen.

Unterhalb eines jeden Zwischenraumes zwischen zwei Rippen befindet sich in der Wand 6,7 je ein Loch 23. Die Löcher 23 bilden eine gerade und parallel zur Unterkante 24 der Halteplatte 5 verlaufende Reihe. Als Aufstützelement für die Unterkante der Leiterplatten 17 erstrecken sich durch diese Löcher Stifte 25.

Diese Stifte 25 sind einstückig mit einem ringförmigen, aus zwei geraden Wänden 26 und seitlich angeordneten V-, U- oder kreisringhälftenförmigen Teilen 27 einstückig hergestellten Einsatzbauelement 28 verbunden. Die Stifte befinden sich auf jeder der Außenseiten der Wände 26. Ihre Anzahl entspricht der Anzahl der Löcher 23.

Eine weitere Reihe von Löchern 29 befindet sich im oberen Teil der Halteplatte 5 zwischen den Spitzen der Rippen 16. In diese Löcher 29 können Stifte eingesetzt werden, die die Möglichkeit des Einschiebens von Leiterplatten 17 in die darunter befindlichen Schlitze 39 zwischen zwei Rippen 16 verhindern und auch dem Fühler eines Roboters als Markierung dienen.

Zwischen jedem Loch 19 und der Außenkante der Halteplatte 5 befindet sich eine keilförmige Vertiefung 30, welche an der Außenkante 31 bzw. 24 tiefer als am Loch 19 ist und der Erleichterung des Aufschiebens der Klammer 20 dient.

In der oberen Stirnfläche 32 der Halteplatte 5 ist ein Loch 33 für den Eingriff eines an einem Roboter angeordneten Stiftes für die Zentrierung vorgesehen.

In Fig. 11 sind zwei Halteplatten 5 dargestellt, die durch Klammern 20 miteinander verbunden sind. Der sich über die ganze untere Platte 5 am oberen Ende erstreckende Vorsprung 38 ist in die obere Halteplatte 5 von unten her eingesteckt, so daß er nicht sichtbar ist. Unter den Klammern 20 ist gestrichelt der Verlauf der Platten dargestellt. Die Schlitze 39 zwischen den Rippen 16 fluchten miteinander. Die untere Halteplatte 5 weist eine bodenparallele Leiste 40 auf, die obere Halteplatte 5 jedoch nicht. Eine derartige Halteplattenkombination dient für solche Leiterplatten, die sich mit ihrer einen Kante über die Höhe beider Platten erstrekken. In Fig. 12 ist eine Seitenansicht ohne Klammern dargestellt, aus der ersichtlich ist, wie der Vorsprung am oberen Ende der unteren Platte in das untere Ende der oberen Platte eingeführt ist.

Liste der Bezugszeichen

| 1 | Transportkasten |
|---|---|
| 2 | Seitenwand |
| 3 | Seitenwand |
| 4 | Stange |
| 5 | Halteplatte |
| 6 | Wand |
| 7 | Wand |
| 8 | Rippe |
| 9 | Rohransatz |
| 10 | Schlitz |
| 11 | Gewinde |
| 12 | Mutter |
| 13 | Konus |
| 14 | Lasche |
| 15 | Rohransatz |
| 16 | Rippe |
| 17 | Leiterplatte |
| 18 | Bauelement |
| 19 | Loch |
| 20 | Klammer |
| 21 | Vorsprung |
| 22 | winkelförmiger Einschnitt |
| 23 | Loch |
| 24 | Unterkante |
| 25 | Stift |
| 26 | Wand |
| 27 | Teil |
| 28 | Einsatzbauelement |
| 29 | Loch |
| 30 | Vertiefung |
| 31 | Außenkante |
| 32 | obere Stirnfläche |
| 33 | Loch |
| 34 | Einkerbung |
| 35 | Raste |
| 36 | Einführungsschräge |
| 37 | Einführungsschräge |
| 38 | Vorsprung |
| 39 | Schlitz |
| 40 | bodenparallele Leiste |

**Patentansprüche**

1. Vorrichtung für den Transport von Leiterplatten, bestehend aus einem Kasten und hohlen, innen mit Aussteifungsrippen (8) versehenen Halteplatten (5), die an ihren Außenseitenflächen (6, 7) eine Vielzahl paralleler Rippen (16) tragen und die mittels sie durchsetzender von einer Kastenwand (2) zur gegenüberliegenden Kastenwand (3) sich erstreckender Stangen (4) zu einer Einheit zusammengehalten sind,
   wobei die Stangen (4) durch geschlitzte, mit Gewinde versehene rohrförmige Ansätze (15) an den Halteplatten (5) gesteckt sind und durch auf die Gewinde aufgeschraubte Muttern geklemmt sind,
   dadurch gekennzeichnet,
   daß die Rippen (16) sich an ihrem oberen Ende in ihrer Breite unter Bildung von Einführungsschrägen (36) verjüngen
   und daß der Querschnitt der Halteplatten (5) sich am oberen Ende unter Bildung mindestens einer weiteren Einführungsschräge (37) verjüngt.

2. Vorrichtung nach Anspruch 1,
   dadurch gekennzeichnet,
   daß zwischen den sich verjüngenden Teilen der Rippen (8) oder über den Zwischenräumen zwischen den Rippen (8) Löcher (29) für die Aufnahme von Sperrstiften angeordnet sind.

3. Vorrichtung nach Anspruch 1,
dadurch gekennzeichnet,
daß mindestens zwei Halteplatten (5) mit gleicher Rippenanordnung übereinander angeordnet sind und durch Klammern (20) miteinander verbunden sind,
und daß vorzugsweise die obere Stirnseite mindestens einer Halteplatte (5) mit mindestens einem in die hohle untere Stirnseite der darüber angeordneten Halteplatte (5) reichenden Vorsprung (38) versehen ist,
wobei vorzugsweise an der unteren Halteplatte (5) mit Abstand vom unteren Ende und unter der Unterkante der Rippen (16) eine bodenparallele Leiste (40) angeordnet ist,
oder wobei im unteren Bereich jeder Seitenwand der gleichgeformten Halteplatten (5) mit Abstand von der Unterkante der Halteplatte Löcher (23) für die Aufnahme von Stiften in einer bodenparallelen Reihe zwischen je zwei Rippen (8) oder in der Flucht der Rippenzwischenräume unter diesen angeordnet sind.

4. Vorrichtung nach Anspruch 3,
dadurch gekennzeichnet,
daß in die hohle von unten her offene Halteplatte (5) ein aus zwei federnd miteinander verbundenen Wandungen (26) bestehendes Bauteil (28) einsetzbar ist, welches im Abstand der Löcher (23) in der Halteplatte (5) an den Außenseitenflächen angeordnete Stifte (25) von geringerem Durchmesser als dem Lochdurchmesser in der Halteplatte (5) trägt, wobei die Stifte (25) länger als die Wandstärke der Halteplatte (5) sind,
wobei vorzugsweise die beiden mit Stiften (5) besetzten Wände (26) an den Schmalseiten durch ein zusammendrückbares Materialteil (27), vorzugsweise in U-, V- oder gerundeter Form, einstückig miteinander verbunden sind.

5. Vorrichtung nach Anspruch 3,
dadurch gekennzeichnet,
daß die Klammern (20) U-Form im Querschnitt aufweisen und an den Innenseiten eines jeden Schenkels mindestens ein Paar von Vorsprüngen (21) aufweisen, welche in Löcher (19) in den Außenseitenflächen der Halteplatten eingreifen,
wobei vorzugsweise die Innenseite der Klammern (20) formschlüssig an der Außenseite der Halteplatte (5) anliegt.

6. Vorrichtung nach Anspruch 3,
dadurch gekennzeichnet,
daß die Vorsprünge (21) an der Klammer durch winkelförmige Einschnitte (22) in die Außenkanten einer aus Blech hergestellten Klammer (20) und Abbiegen des im Einschnitt liegenden Materials nach innen hergestellt sind.

7. Vorrichtung nach Anspruch 3,
dadurch gekennzeichnet,
daß zwischen jedem Loch (19) in der Halteplatte (5) für die Aufnahme eines Vorsprunges (21) an der Klammer (20) und der Außenkante (24, 31) der Halteplatte (5) eine keilförmige, senkrecht zur Außenkante verlaufende Vertiefung (30) angeordnet ist, welche ihre größte Tiefe an der Außenkante (24, 31) und ihre geringste Tiefe an der Ausnehmung (19) aufweist.

8. Vorrichtung nach Anspruch 1,
dadurch gekennzeichnet,
daß die obere Stirnfläche (32) der Halteplatte (5) mindestens ein der Zentrierung dienendes Loch (33) aufweist.

9. Vorrichtung nach Anspruch 1,
dadurch gekennzeichnet,
daß die Stange Mittel für die Arretierung, vorzugsweise in Form von Löchern, Kerben (34) Zähnen oder dergleichen aufweist und daß an der Platte, insbesondere am oder neben dem rohrförmigen Ansatz mit diesen Mitteln zusammenarbeitende Mittel, vorzugsweise in Form von Splinten, Löchern, Bolzen, Federn, Rasten (35), Zähnen, Haken angeordnet sind.

10. Vorrichtung nach Anspruch 1,
dadurch gekennzeichnet,
daß die Stäbe (4) rechteckförmigen Querschnitt aufweisen.

## Claims

1. A device for transporting circuit boards, comprising a container and hollow support plates (8) which are internally provided with stiffening ribs (5) and which, on their outer side surfaces (6, 7), bear a plurality of parallel ribs (16) and which are held together to form a unit by means of rods (4) which pass through the support plates and extend from one container wall (2) to the opposite container wall (3), where the rods (4) are attached to the support plates (5) by slotted, tubular shoulders provided with threading and are clamped by nuts screwed onto the threading, characterised in that the ribs (16) reduce in width at their upper end so as to form insertion lead-ins (36) and that the cross-section of the support plates (5) tapers at the upper end so as to form at least one further insertion lead-in (37).

2. A device as claimed in Claim 1, characterised in that holes (29) for the accommodation of locking pins are disposed between the tapering parts of the ribs (8) or above the spaces between the ribs (8).

3. A device as claimed in Claim 1, characterised in that at least two support plates (5) with an identical rib arrangement are disposed one above another and are connected to one another by clips (20), and that preferably the upper end side of at least one support plate (5) is provided with at least one projection (38) which extends into the hollow, lower end side of the overlying support plate (5), where preferably a strip (40), extending in parallel to the base, is arranged on the lower support plate (5) at a distance from the lower end and beneath the lower edge of the ribs (16), or where, in the lower region of each side wall of the support plates (5) of identical formation, at a distance from the lower edge of the support plate holes (23) for the accommodation of pins are disposed in a row, extending in parallel to the base, between two respective ribs (8) or in alignment with the spaces between the ribs below the latter.

4. A device as claimed in Claim 3, characterised in that a component (28) composed of two walls (26), resiliently connected to one another, can be inserted into the hollow support plate (5) which is open at the bottom, which component (28) bears pins (25), which are arranged at a distance from the holes (23) in the support plate (5) on the outer side surfaces of said support plate, and which possess a smaller diameter than the diameter of the holes in the support plate (5), where the length of the pins (25) is greater than the wall thickness of the support plate (5), where preferably the two walls (26) equipped with pins (5) are integrally connected to one another at the narrow sides via a compressible material component (27), preferably of U-, V- or rounded formation.

5. A device as claimed in Claim 3, characterised in that the clips (20) are U-shaped in cross-section and on the inner sides of each leg comprise a pair of projections (21) which engage into holes (19) in the outer side surfaces of the support plates, where preferably the inside of the clips (20) bears against the outside of the support plate (5) in an interlockingly engaging fashion.

6. A device as claimed in Claim 3, characterised in that the projections (21) of the clip are formed by angular indentations (22) in the outer edges of a clip (20) produced from sheet metal, and by inwardly bending the material located in the indentation.

7. A device as claimed in Claim 3, characterised in that between each hole (19) in the support plate (5) for the accommodation of a projection (21) of the clip (20), and the outer edge (24, 31) of the support plate (5) is arranged a wedge-shaped recess (30) which extends at right angles to the outer edge and which has its greatest depth at the outer edge (24, 31) and its smallest depth at the recess (19).

8. A device as claimed in Claim 1, characterised in that the upper end surface (32) of the support plate (5) contains at least one hole (33) which serves for centring.

9. A device as claimed in Claim 1, characterised in that the rod comprises locking means, preferably in the form of holes, grooves (34), teeth or the like and that on the plate, in particular on or next to the tubular shoulder are arranged means with which cooperate with the aforementioned means and which preferably have the form of split pins, holes, bolts, springs, notches (35), teeth, or hooks.

10. A device as claimed in Claim 1, characterised in that the rods (4) are of rectangular cross-section.

**Revendications**

1. Dispositif destiné au transport de cartes de circuits imprimés, composé d'un boîtier et de plaques de support creuses (5), pourvues à l'intérieur de nervures de raidissement (8) qui portent sur leurs faces latérales extérieures (6,7) plusieurs nervures parallèles et qui sont maintenues en un ensemble au moyen de tiges (4) qui traversent ces dernières et qui s'étendent d'une paroi (2) de boîtier à la paroi opposée (3) de boîtier,

les tiges (4) étant enfoncées sur les plaques porteuses (5) à travers des appendices tubulaires fendus (15), pourvus d'un filetage, et étant serrés par des écrous vissés sur les filetages,

caractérisé

en ce que les nervures (16) se réduisent en largeur sur leur extrémité supérieure en formant des pentes d'introduction (36)

et en ce que la section transversale des plaques de support (5) se réduit à l'extrémité supérieure en formant au moins une autre pente d'introduction (37).

2. Dispositif selon la revendication 1, caractérisé

en ce que des trous (29) destinés à recevoir des tiges de blocage sont ménagés entre les parties qui se réduisent des nervures (8) ou au-dessus des espaces intermédiaires entre les nervures (8).

3. Dispositif selon la revendication 1, caractérisé

en ce qu'au moins deux plaques de support (5) de même agencement de nervures sont superposées l'une à l'autre et sont reliées entre elles par des agrafes (20),

et en ce que, de préférence, la face frontale supérieure d'au moins une plaque de support (5) est pourvue d'au moins une saillie (38) pénétrant dans la face frontale inférieure creuse de la plaque de support (5) qui lui est superposée,

une baguette (40) parallèle au fond étant de préférence disposée sur la plaque de support inférieure (5) à distance de l'extrémité inférieure et sous l'arête inférieure des nervures (16),

ou des trous (23) destinés à recevoir des tiges étant disposés en une rangée parallèle au fond, chacun entre chaque paire de nervures ou dans l'alignement des espaces intermédiaires de nervures au dessous de celles-ci, dans la zone inférieure de chaque paroi latérale des plaques de support (5) de même forme, à distance de l'arête intérieure de la plaque de support.

4. Dispositif selon la revendication 3, caractérisé

en ce que, dans les plaques de support (5) creuses ouvertes vers le bas, il peut être inséré un composant (28), constitué de deux parois (26) reliées de manière élastique entre elles, qui porte des tiges (25), d'un diamètre plus petit que le diamètre du trou des plaques support (5), disposées à distance des trous (23) dans la plaque de support (5) sur les surfaces latérales extérieures, les tiges (25) étant plus longues que l'épaisseur de paroi de la plaque de support (5),

les deux parois (26) pourvues de tiges (5) étant de préférence reliées entre elles d'un seul tenant sur les petits côtés par un élément (27) en matière compressible, de préférence en U, en V ou de forme arrondie.

5. Dispositif selon la revendication 3, caractérisé

en ce que les agrafes (20) présentent en coupe transversale une forme de U et comportent sur les côtés intérieurs de chaque branche au moins une paire de saillies (21) qui pénètrent dans des trous (19) dans les surfaces latérales extérieures des plaques de support,

le côté intérieur des agrafes (20) reposant de préférence en engagement positif sur le côté extérieur de la plaque de support (5).

6. Dispositif selon la revendication (3), caractérisé

en ce que les saillies (21) sur l'agrafe sont réalisées par des découpes de forme angulaire (22) dans les arêtes extérieure d'une agrafe (20) en tôle et par pliage vers l'intérieur de la matière située dans la découpe.

7. Dispositif selon la revendication 3, caractérisé

en ce qu'un évidement (30) en biais, de tracé perpendiculaire à l'arête extérieure, est ménagé entre chaque trou (19) de la plaque de support (5) pour recevoir une saillie (21) sur l'agrafe (20) et l'arête extérieure (24, 31) de la plaque de support (5), l'évidement (30) présentant sa plus grande profondeur sur l'arête extérieure (24, 31) et sa plus faible profondeur à l'évidement (19).

8. Dispositif selon la revendication 1, caractérisé

en ce que la surface frontale supérieure (32) de la plaque de support (5) comporte au moins un trou (33) servant au centrage.

9. Dispositif selon la revendication 1, caractérisé

en ce que la tige comporte des moyens pour le blocage, de préférence sous forme de trous, d'entailles (34), de dents ou similaires et en ce que des moyens coopérant avec ces moyens, de préférence en forme de goupilles, de trous, de boulons, de ressorts, de cliquets (35), de dents, de crochets sont disposés sur la plaque, en particulier sur l'appendice tubulaire ou près de celui-ci.

10. Dispositif selon la revendication 1, caractérisé

en ce que les barres (4) sont de forme rectangulaire en coupe transversale.

FIG. 1

FIG. 2

FIG.3

FIG.4

FIG.6

EP 0 256 164 B1

FIG.8

FIG.9

FIG.10

FIG.5

FIG.7

EP 0 256 164 B1

FIG.12

FIG.11